(19) Europäisches Patentamt
European Patent Office
Office européen des brevets

(11) **EP 3 978 235 A1**

(12) **EUROPEAN PATENT APPLICATION**
published in accordance with Art. 153(4) EPC

(43) Date of publication:
06.04.2022 Bulletin 2022/14

(21) Application number: 20813821.4

(22) Date of filing: 26.05.2020

(51) International Patent Classification (IPC):
*B32B 9/00* (2006.01)   *C23C 14/08* (2006.01)
*C23C 14/24* (2006.01)   *C23C 14/58* (2006.01)

(52) Cooperative Patent Classification (CPC):
**B32B 9/00; C23C 14/08; C23C 14/24; C23C 14/58**

(86) International application number:
**PCT/JP2020/020687**

(87) International publication number:
**WO 2020/241621 (03.12.2020 Gazette 2020/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: 31.05.2019 JP 2019102710
31.05.2019 JP 2019102711

(71) Applicant: TOYOBO CO., LTD.
**Osaka-shi**
**Osaka 530-8230 (JP)**

(72) Inventors:
• **ISEKI, Kiyoshi**
  **Inuyama-shi, Aichi 484-8508 (JP)**
• **IWATA, Daisuke**
  **Inuyama-shi, Aichi 484-8508 (JP)**

(74) Representative: **Vossius & Partner**
**Patentanwälte Rechtsanwälte mbB**
**Siebertstraße 3**
**81675 München (DE)**

(54) **TRANSPARENT GAS BARRIER FILM AND METHOD FOR PRODUCING SAME**

(57) An object of the present invention is to provide a transparent barrier film that has excellent acid resistance and is inexpensive, and a method for producing the same. A transparent gas barrier film includes a plastic film and an aluminum oxide layer provided on at least one surface of the plastic film, the aluminum oxide layer mainly composed of aluminum oxide. The absorption coefficient of the inorganic oxide layer immediately after vapor-deposition is less than 0.03 nm$^{-1}$, and the film thickness of the inorganic oxide layer is 6 nm or more and 10 nm or less.

Fig.3

EP 3 978 235 A1

**Description**

TECHNICAL FIELD

The present invention relates to a transparent barrier film having excellent properties as a packaging material that has excellent transparency, gas barrier properties, printability, and flexibility and is required to provide the airtightness of foods, pharmaceuticals, and electronic components and the like, or a gas blocking material, and a method for producing the same.

BACKGROUND ART

As a transparent barrier film, a film obtained by laminating an inorganic substance on a plastic film is commercially available. As the inorganic substance, metal oxides such as silicon oxide and aluminum oxide are often used from the viewpoint of transparency. The metal oxide is mainly laminated on a film by a vapor-deposition method or a CVD method.

In particular, a laminated film that includes, as a barrier layer, an aluminum oxide layer formed by a reactive vapor-deposition method of evaporating aluminum and introducing oxygen is mainly used (see, for example, Patent Document 1).

The following transparent barrier film is also commercially available. On the transparent barrier film, an inorganic layer is laminated, and the inorganic layer is coated with an organic layer or the like to improve the barrier properties of the film or protect the inorganic layer (see, for example, Patent Document 2).

The transparent barrier film is used in a state where the film is subjected to printing when used for a packaging material, or other film is laminated on the film using an adhesive or the like. Various films are laminated, but an un-stretched polyethylene film or polypropylene film called a sealant is generally laminated in order to make a bag.

In the transparent barrier film having an aluminum oxide layer formed by reactive vapor-deposition used in Patent Documents 1 and 2, a vapor-deposition material is inexpensive aluminum, and the evaporation temperature of aluminum is also low, whereby the transparent barrier film can be formed by a relatively inexpensive apparatus having an induction heating type or resistance heating type vapor-deposition source. Therefore, the transparent barrier film having the aluminum oxide layer is provided as a packaging material at a lower cost than that of a transparent barrier film containing silicon oxide or silicon oxide and aluminum oxide as a vapor-deposition material. However, when acidic contents are put into a bag formed by using the transparent barrier film having the aluminum oxide layer, the barrier properties of the bag are deteriorated, which disadvantageously causes the deterioration in the contents to proceed.

Patent Document 2 introduces coating on an aluminum oxide layer, but the coating makes it impossible to provide improved acid resistance.

Patent Document 1 discloses a production method in which sufficient barrier properties are less likely to be obtained with a film thickness of 100 nm or less in a reactive vapor-deposition method in which aluminum is evaporated and oxygen is blown, whereby vapor-deposition is performed under a pressure of $1 \times 10^{-5}$ to $1 \times 10^{-2}$ Torr ($1.33 \times 10^{-3}$ to 1.33 Pa) in a vacuum pressure vessel, and the film is then stored under conditions of 40°C and 80% RH, or immersed in warm water to temporarily adsorb moisture, followed by performing a heat treatment.

In the production method, it is considered that the barrier properties can be improved, but unreacted aluminum is combined with water to form aluminum hydroxide, whereby the obtained film is apt to react with an acid.

Patent Document 2 discloses a production method in which a vapor-deposited inorganic layer having an ultraviolet transmittance (366 nm) of 82 to 94% is provided, and a coating layer is provided thereon by a sol-gel method.

In the production method, the film thickness is 10 nm or more, whereby the ultraviolet transmittance of 82% or less is considered to cause poor transparency, and the ultraviolet transmittance of 94% or more is considered to provide no reactivity with the coating layer. In the production method, the degree of oxidation during vapor-deposition is increased to provide improved transparency, thereby causing the coating layer to improve the barrier properties. The production method increases the number of steps, which makes it difficult to inexpensively produce the film. When an oxide layer obtained by oxidizing aluminum is used, the coating layer cannot prevent a reaction due to an acid.

Therefore, for coping, there is used a barrier layer composed of silicon oxide as an expensive vapor-deposition material, or a layer formed by an expensive vapor-deposition apparatus using an electron beam vapor-deposition source and obtained by mixing silicon oxide with aluminum oxide.

PRIOR ART DOCUMENTS

PATENT DOCUMENT

Patent Document 1: JP-B-2638797
Patent Document 2: JP-A-2007-290292

DISCLOSURE OF THE INVENTION

PROBLEMS TO BE SOLVED BY THE INVENTION

The present invention has been made in view of the problems of the conventional technique. That is, an object of the present invention is to provide a transparent barrier film that has excellent acid resistance and is inexpensive, and a method for producing the same.

As a result of intensive studies, the present inventors have found that the above problems can be solved by the following means, and have reached the present invention. That is, the present invention has the following configurations.

1. A transparent gas barrier film comprising a plastic film and an aluminum oxide layer provided on at least one surface of the plastic film, the aluminum oxide layer mainly composed of aluminum oxide, wherein:

an absorption coefficient of the aluminum oxide layer immediately after vapor-deposition is less than $0.03 \text{ nm}^{-1}$; and

a film thickness of the aluminum oxide layer is 6 nm or more and 10 nm or less.

2. The transparent gas barrier film according to 1., wherein the absorption coefficient immediately after vapor-deposition is $0.02 \text{ nm}^{-1}$ or more.

3. The transparent gas barrier film according to 1. or 2., wherein the absorption coefficient is finally $0.02 \text{ nm}^{-1}$ or less.

4. A method for producing a transparent gas barrier film comprising a plastic film and an aluminum oxide layer provided on at least one surface of the plastic film, the aluminum oxide layer mainly composed of aluminum oxide, the method comprising an aluminum oxide layer forming step of adjusting an absorption coefficient of the aluminum oxide layer immediately after vapor-deposition to less than $0.03 \text{ nm}^{-1}$ and adjusting a film thickness of the aluminum oxide layer to 6 nm or more and 10 nm or less.

5. The method according to 4., wherein in the aluminum oxide layer forming step, the absorption coefficient immediately after vapor-deposition is adjusted to $0.02 \text{ nm}^{-1}$ or more.

6. The method according to 4. or 5., wherein the aluminum oxide layer forming step is performed by using a reactive vapor-deposition method.

7. The method according to any one of 4. to 6., wherein the absorption coefficient is adjusted by controlling an amount of oxygen introduced into a vapor-deposition tank in the aluminum oxide layer forming step.

8. The method according to any one of 4. to 7., further comprising a step of finally adjusting the absorption coefficient to $0.002 \text{ nm}^{-1}$ or less after the aluminum oxide layer forming step.

9. The method according to 5., wherein the transparent gas barrier film is stored at normal temperature in an air atmosphere for 1 week or more in the step of adjusting the absorption coefficient to $0.002 \text{ nm}^{-1}$ or less.

EFFECT OF THE INVENTION

The present invention makes it possible to provide a transparent gas barrier film that is inexpensive, has excellent transparency, can retain barrier properties even when packaging acidic contents, and can store the contents for a long period of time, and a method for producing the same.

BRIEF DESCRIPTION OF THE DRAWINGS

Fig. 1 shows transmittance wavelength characteristics of a substrate plastic film and a transparent gas barrier film measured by a spectrophotometer.
Fig. 2 shows transmittance wavelength characteristics of a substrate plastic film, a D65 light source, and a color-matching function of a CIE standard colorimetric observer.
Fig. 3 is a schematic vapor-deposition view.
Fig. 4 is a schematic vapor-deposition view.
Fig. 5 is a schematic view of a vapor-deposition apparatus.

MODE FOR CARRYING OUT THE INVENTION

Hereinafter, the present invention will be described in detail.

A transparent gas barrier film of the present invention includes a plastic film and an aluminum oxide layer provided on at least one surface of the plastic film, the aluminum oxide layer mainly composed of aluminum oxide. An absorption coefficient of the aluminum oxide layer immediately after vapor-deposition is less than $0.03$ nm$^{-1}$, and a film thickness of the aluminum oxide layer is 6 nm or more and 10 nm or less.

A method for producing a transparent gas barrier film of the present invention is a method for producing a transparent gas barrier film including a plastic film and an aluminum oxide layer provided on at least one surface of the plastic film, the aluminum oxide layer mainly composed of aluminum oxide. The method includes an aluminum oxide layer forming step of adjusting an absorption coefficient of the aluminum oxide layer immediately after vapor-deposition to less than $0.03$ nm$^{-1}$ and adjusting a film thickness of the aluminum oxide layer to 6 nm or more and 10 nm or less.

The aluminum oxide layer mainly composed of aluminum oxide in the present invention substantially contains 99% or more of aluminum oxide and other components as impurities. The aluminum oxide contains not only a stoichiometrically complete oxide but also aluminum oxide that is deficient in oxygen.

When the total light transmittance of the aluminum oxide layer is Tal % and the film thickness of the aluminum oxide layer is tal nm, the absorption coefficient $\alpha$ in the present invention can be represented by Formula 1.

$$\alpha = -1/\mathrm{tal}\cdot\ln(\mathrm{Tal}/100) \qquad \cdots \text{Formula (1)}$$

When the total light transmittance of the transparent gas barrier film having the aluminum oxide layer is T0 % and the total light transmittance of the substrate plastic film on which the aluminum oxide layer is laminated is Tb %, the total light transmittance Tal % of the aluminum oxide layer can be represented by Formula (2).

$$\mathrm{Tal} = \mathrm{T0}/\mathrm{Tb}\times100 \qquad \cdots \text{Formula (2)}$$

The film thickness of the aluminum oxide layer of the present invention is a value determined by a fluorescent X-ray apparatus with the density of the aluminum oxide thin film being 0.74 times (2.94 g/cm$^3$) a bulk density (3.97 g/cm$^3$). The reason why the density of the aluminum oxide thin film is 0.74 times the bulk density is that the film thickness is well matched with an actual film thickness obtained by TEM or the like.

In order to obtain the film thickness using the fluorescent X-ray apparatus, it is necessary to measure a sample having a known film thickness in advance using the fluorescent X-ray apparatus, obtain a fluorescent X-ray dose emitted from the sample, and create a calibration curve of the film thickness and fluorescent X-ray intensity.

In a sample used for creating a calibration curve of fluorescent X-rays, an aluminum adhesion amount per unit area is identified by inductively coupled plasma emission spectroscopy, and the aluminum adhesion amount is converted into a film thickness by the density of an aluminum oxide thin film, to measure the film thickness.

The total light transmittance in the present invention refers to a total light transmittance according to JIS K7375. In an optical film thickness meter installed to measure a film thickness in a vapor-deposition apparatus, a light source such as a fluorescent lamp, a xenon lamp, or a white LED is used to make light incident on one surface to be measured and measure an amount of light emitted from the other. The measured value is correlated to a total light transmittance of a sample measured in advance according to JIS K7375 with the optical film thickness meter, and treated as the total light transmittance.

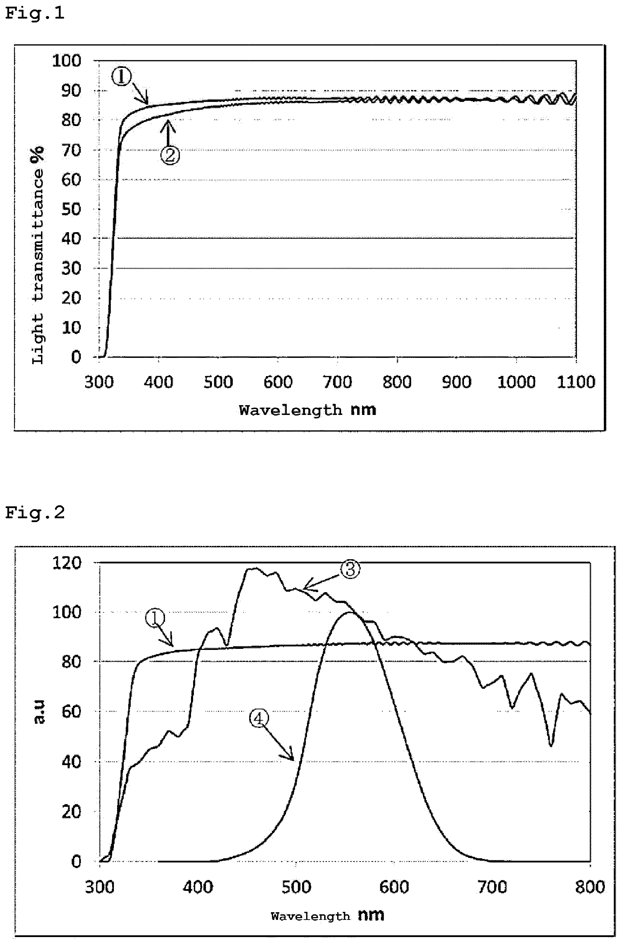

Fig. 1 shows a graph obtained by measuring light transmittances of a substrate plastic film and a transparent barrier film by a spectrophotometer. The light transmittance 2 of the transparent barrier film causes monotonous light absorption at any wavelength as compared with the light transmittance 1 of the substrate plastic film. A value obtained by converting the value of the optical film thickness meter can also be treated as the total light transmittance in consideration of a D65 light source as defined as a light source in JIS K7375 and the wavelength region of the color-matching function of a CIE standard colorimetric observer. Fig. 2 shows a wavelength region.

The transparent gas barrier film of the present invention includes a plastic film and an aluminum oxide layer provided on at least one surface of the plastic film, the aluminum oxide layer mainly composed of aluminum oxide. An absorption coefficient of the aluminum oxide layer immediately after vapor-deposition is less than $0.03$ nm$^{-1}$.

A method for producing a transparent gas barrier film of the present invention is a method for producing a transparent gas barrier film including a plastic film and an aluminum oxide layer provided on at least one surface of the plastic film, the aluminum oxide layer mainly composed of aluminum oxide. The method includes an aluminum oxide layer forming step of adjusting an absorption coefficient of the aluminum oxide layer immediately after vapor-deposition to less than $0.03$ nm$^{-1}$.

"Immediately after vapor-deposition" in the present invention refers to a time point when an optical thickness is measured for film thickness control or the like immediately after an aluminum oxide layer is vapor-deposited on a plastic film in a vacuum chamber.

When the vapor-deposited aluminum oxide layer comes into contact with oxygen, the oxidation of the aluminum oxide layer further proceeds, which causes change in the total light transmittance.

After the completion of the vapor-deposition, the plastic film after vapor-deposition is taken out from the vapor-deposition apparatus, and the total light transmission amount is immediately measured, which coincides with that at the time point when the optical thickness is measured.

Even if the transparent barrier film is exposed to the atmosphere to promote the oxidation of the transparent barrier film, and a bag is formed by using the transparent barrier film to package an acidic substance, the absorption coefficient immediately after vapor-deposition of 0.03 $nm^{-1}$ or more causes deteriorated barrier properties of the bag. That is, the barrier film has poor acid resistance. The absorption coefficient immediately after vapor-deposition is preferably less than 0.03 $nm^{-1}$.

It is unclear whether the acid molecules have a structure of easily approaching to the metal atoms, or the metal oxide atoms are in a state of easily reacting with acids, but deterioration in the barrier film due to the acids occurs.

The acid resistance in the present invention means that an aluminum oxide layer as a barrier layer does not lose its barrier properties due to chemical change in the aluminum oxide layer caused by acids when highly acidic contents are put in a package including a transparent barrier film.

The absorption coefficient of the transparent gas barrier film of the present invention immediately after vapor-deposition is preferably 0.02 $nm^{-1}$ or more. In the method for producing a transparent gas barrier film of the present invention, the absorption coefficient immediately after vapor-deposition is preferably adjusted to 0.02 $nm^{-1}$ or more. When the absorption coefficient is 0.02 $nm^{-1}$ or less, the degree of oxidation of aluminum oxide is high, which provides improved transparency, but a water vapor transmission rate is reduced, which is not preferable as the barrier film.

It is presumed that the aluminum oxide layer largely reacts with oxygen during vapor-deposition, which causes a decreased density of the aluminum oxide layer, but it is not clear.

"The absorption coefficient is finally 0.002 $nm^{-1}$ or less" in the present invention, or "the step of finally adjusting the absorption coefficient to 0.002 $nm^{-1}$ or less" means that the absorption coefficient is 0.002 $nm^{-1}$ or less or adjusted to 0.002 $nm^{-1}$ or less when the absorption coefficient is obtained after the transparent barrier film in which the aluminum oxide layer is laminated on the substrate plastic film by vapor-deposition is taken out from the vacuum chamber, and the transparent barrier film is stored at least at room temperature of 10°C to 40°C for 1 week or more in a state where the aluminum oxide layer is exposed to the atmosphere.

In the transparent gas barrier film of the present invention, the thickness of the aluminum oxide vapor-deposited layer is 6 nm or more and 10 nm or less. The method for producing a transparent gas barrier film of the present invention includes an aluminum oxide layer forming step of adjusting the thickness of the aluminum oxide layer to 6 nm or more and 10 nm or less.

When the absorption coefficient finally exceeds 0.002 $nm^{-1}$, the light absorption of the thin film exceeds 1% even if the film thickness is 10 nm or less, which disadvantageously causes coloring. The coloring can also be suppressed by reducing the film thickness, but when the film thickness is 5 nm or less, the barrier properties become problematic.

As a method for producing a transparent barrier film having an aluminum oxide layer having a film thickness of 10 nm or less and an absorption coefficient immediately after vapor-deposition of 0.03 $nm^{-1}$ or less, a reactive vapor-deposition method is suitable.

The reactive vapor-deposition method is a method in which oxygen is introduced into a vapor-deposition tank where metal aluminum is evaporated by heating, to oxidize the metal aluminum, thereby depositing aluminum oxide on a substrate plastic film. As a method for evaporating metal aluminum by heating, a resistance heating method, an induction heating method, and an electron beam heating method can be used.

Examples of a method for controlling the film thickness include a method in which an aluminum oxide layer deposited on a plastic film is measured with a film thickness meter using fluorescent X-rays, and the heating is adjusted to control the film thickness in comparison with the target film thickness. In this case, in order to set the absorption coefficient to 0.03 $nm^{-1}$ or less, a photometer that irradiates light from one side of the plastic film and measures light transmitted from the other side is installed, to control the amount of oxygen introduced according to the amount of the total transmission light.

Alternatively, metal aluminum is first vapor-deposited on the substrate plastic film. The thickness of the deposited metal aluminum is controlled by an optical film thickness meter that irradiates light from one side of the plastic film after vapor-deposition and measures light transmitted from the other side to convert the measured value into a film thickness, thereby making the film thickness constant. Thereafter, oxygen is introduced to deposit aluminum oxide. At that time, there is used a production method in which an optical film thickness meter is used as a measurement meter of the total light transmittance under a constant evaporation condition to control the amount of oxygen introduced so as to achieve the target total light transmittance. The latter production method is preferable because the apparatus is simple.

In the production method using the optical film thickness meter, a resistance heating method in which an aluminum wire as an evaporation source is supplied to a boat type heating element to evaporate the aluminum wire is suitable. After oxygen is introduced, the film thickness cannot be calculated from the total light transmittance. In the boat-type evaporation source, aluminum as an evaporation material is supplied in a wire form. Accordingly, it is found that if a wire supply speed when an evaporation amount reaches the target is maintained, if the evaporation is delayed, molten aluminum on the boat increases and the evaporation amount decreases. When the evaporation amount increases, the supply of the wire cannot catch up the increase, whereby the evaporation amount does not exceed a certain level. As described above, when the vapor-deposition rate of aluminum is once determined, the evaporation amount is stabilized, which is preferable.

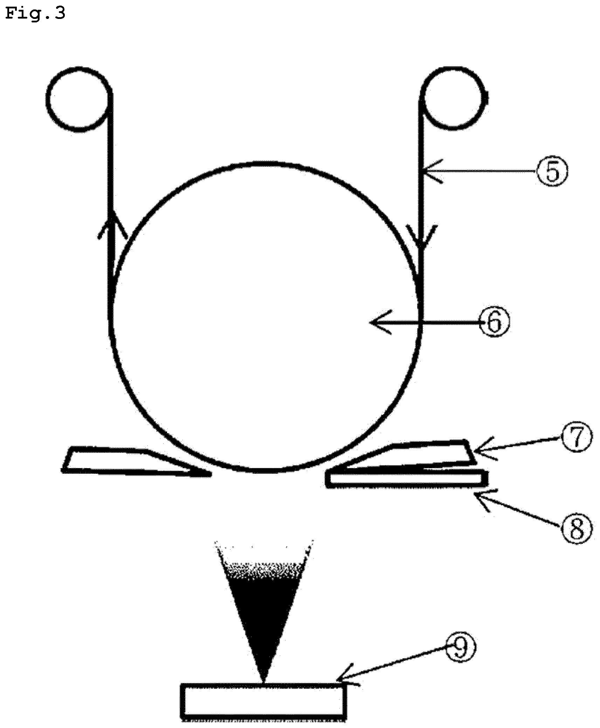

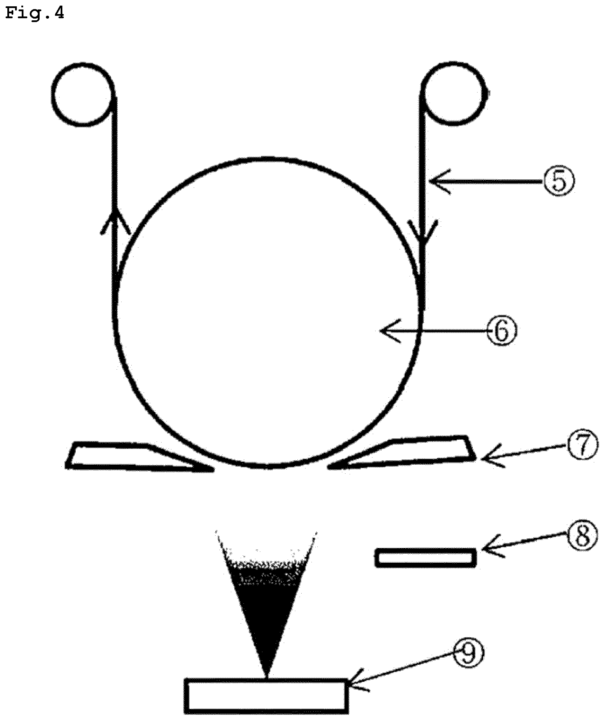

Figs. 3 and 4 show schematic views of the vapor-deposition apparatus. Aluminum evaporating from a vapor-deposition source (9) is deposited on a substrate plastic film (5) on a coating roll (6). A coating window (7) is installed near the coating roll (6) in order to limit the angle of incidence of aluminum vapor on the substrate or to prevent the adhesion of aluminum to unnecessary places.

As shown in Fig. 3, an oxygen inlet (8) is preferably installed close to the coating roll (6) so as not to hinder the flow of the aluminum vapor.

It is considered that when the oxygen inlet (8) is brought close to the evaporation source as shown in Fig. 4, aluminum is oxidized at the evaporation source, which causes an unstable evaporation rate. As shown in Fig. 4, when oxygen is introduced at a position away from the flow of the aluminum vapor, the probability that the oxygen encounters aluminum atoms decreases, whereby the oxygen is not effectively used. Unconsumed oxygen increases a pressure in a vacuum vapor-deposition tank. When vapor-deposition is performed in a situation where the pressure is high, the density of the formed film tends to decrease.

A decrease in the density of the aluminum oxide is estimated to cause reduced ability to hinder the permeation of a gas. Therefore, a pressure for performing vapor-deposition is preferably $1 \times 10^{-2}$ Pa or less in consideration of the fact that the density of the aluminum oxide increases to provide improved barrier properties.

In Fig. 4, the oxygen inlet (8) can be placed in the aluminum vapor to increase the efficiency, but aluminum or aluminum oxide adheres to the oxygen inlet to cause reduced efficiency of the deposition thereof on the substrate plastic film. When the deposited material adhering to the oxygen inlet (8) peels, drops, and enters the evaporation source, the evaporation amount changes, which is not preferable.

In the method for producing a transparent barrier film, vapor-deposition is preferably performed by a roll-to-roll method. Because the plastic film after vapor-deposition is taken out in a roll form, the aluminum oxide layer is not exposed to the atmosphere. Therefore, it is necessary to rewind the rolled plastic film once in the atmosphere to entrain air between layers of the plastic film. As a rewinding condition, it is preferable to rewind the plastic film under a condition that an air layer of 0.4 μm or more is entrained. When the plastic film is rewound under a high-temperature high-humidity atmosphere, the plastic film after vapor-deposition may be blocked due to dew formation, whereby it is preferable that the temperature is 40°C or less, and the relative humidity is 70 RH% or less.

The amount of air entrained can be represented by Formula 3. When the thickness of the rewound plastic film is t μm; the length thereof is 1 m; the diameter of a paper tube used is 2r mm; and the diameter of the wound rolled plastic film is 2R mm, the thickness tair μm of the layer of air entrained between the plastic films can be represented by Formula 3.

$$\mathtt{tair = \pi(R^2-r^2)/l-t \quad Formula \ (3)}$$

The rewound rolled plastic film is preferably stored until the aluminum oxide layer is stabilized because the oxidation of the aluminum oxide layer gradually proceeds. A storage period needs to be at least 1 week at room temperature of 10°C to 40°C.

An increase in the temperature is presumed to promote the oxidation, but an increase in the temperature to 40°C or higher may affect the physical properties and the like of the film, which is not preferable. The temperature of 10°C or lower causes delayed oxidation, which is not preferable.

The plastic film in the present invention is a film obtained by melt-extruding an organic polymer, stretching the organic polymer in a longitudinal direction and/or a transverse direction as necessary, and cooling and thermosetting the organic polymer. Examples of the organic polymer include polyethylene, polypropylene, polyethylene terephthalate, polyethylene-2,6-naphthalate, nylon 6, nylon 4, nylon 66, nylon 12, polyvinyl chloride, polyvinylidene chloride, polyvinyl alcohol, wholly aromatic polyamide, polyamide imide, polyimide, polyether imide, polysulfone, polyphenylene sulfide, and polyphenylene oxide. These organic polymers may be copolymerized or blended with a small amount of other organic polymer.

Furthermore, to this organic polymer, known additives such as an ultraviolet absorber, an anti-static agent, a plasticizer, a lubricant, and a coloring agent may be added, and a plastic film having a total light transmittance of 70% or more is preferable from the viewpoint of the plastic film utilizing the transparency, but the transparency of the plastic film is not particularly limited. The total light transmittance is more preferably 80% or more.

The plastic film used in the present invention may be subjected to a corona discharge treatment, a glow discharge treatment, or other surface roughening treatment before laminating a thin-film layer thereto, or may be subjected to a known anchor coating treatment. The thickness of the plastic film used in the present invention is preferably in the range of 5 to 1000 $\mu$m, and more preferably in the range of 10 to 500 $\mu$m.

The aluminum oxide layer of the present invention is relatively hard because the aluminum oxide layer has an increased density to provide improved barrier properties. Therefore, the plastic film preferably has good dimensional stability. An un-stretched plastic film cannot be said to be preferable because the un-stretched plastic film is apt to be deformed by tension. A polyamide film made of nylon or the like having a large dimensional change due to humidity or the like cannot be said to be also preferable.

It is preferable to use a biaxially stretched polyethylene terephthalate film or a biaxially stretched polypropylene film that has a small dimensional change due to humidity and temperature.

In the vapor-deposition step, the substrate plastic film is heated by radiant heat from the vapor-deposition source and heat dissipation accompanying the phase change of aluminum from a gas phase to a solid phase. From this viewpoint, a biaxially stretched film of polyester terephthalate having relatively excellent heat resistance is preferable.

EXAMPLES

Hereinafter, the present invention will be specifically described with reference to Examples, but the present invention is not limited to Examples.

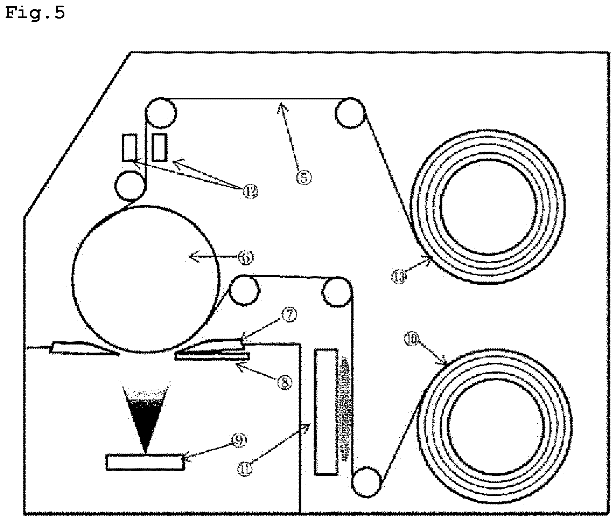

A transparent barrier film was formed by using a vapor-deposition apparatus, shown in a schematic view described in Fig. 5, having a vapor-deposition source in which boat-type resistance heating vapor-deposition sources (9) were arranged, and a roll-to-roll-type film traveling system.

An aluminum wire is fed into a boat made of BN composite.

An oxygen inlet (8) is installed in a coating window (7) .

A coating roll (6) was set at -5°C.

A substrate plastic film (5) used for vapor-deposition is a 12 $\mu$m-thick polyethylene terephthalate plastic film for vapor-deposition of a Toyobo ester (R) film.

The substrate plastic film (5) is unwound from an unwinding roll (10). A vapor-deposition surface of the plastic film (5) is treated by a planar type plasma source (11), and the plastic film (5) is guided to the coating roll (6).

The plasma source (11) generated plasma in a state where an input power was set to 10 kW, and an argon gas of 400 sccm and an oxygen gas of 100 sccm were caused to flow.

The substrate plastic film (5) is guided to a coating window position for vapor-deposition by the coating roll (6) after the surface treatment.

The plastic film after vapor-deposition is caused to move to an optical film thickness meter (12) to measure a total light transmittance. After the measurement, the film is wound around a winding roll (13).

The total light transmittance during vapor-deposition was obtained by converting the value of the optical film thickness meter by using a sample measured by a turbidimeter (NDH 5000 manufactured by Nippon Denshoku Industries Co., Ltd.) according to JIS K7375.

The sample taken out after vapor-deposition was measured with the turbidimeter.

An oxygen transmission rate (OTR) was measured under measurement conditions of a temperature of 23°C and a humidity of 65%RH using an oxygen transmission measuring apparatus (OXTRAN-2/20 manufactured by MOCON Inc.) according to JIS K7126-2.

A water vapor transmission rate (WVTR) was measured under measurement conditions of a temperature of 40°C and a humidity of 90%RH using a water vapor transmission measuring apparatus (PERMATRAN-W3/31 manufactured by MOCON Inc.,US) according to JIS K7129B.

Acid resistance was evaluated as follows.

First, a laminated film is formed by dry-laminating a linear low density polyethylene film (LLDPE: L4102 40 $\mu$m, manufactured by Toyobo Co., Ltd.) on the formed transparent barrier film. For the dry lamination, an adhesive obtained by mixing TM569 and CAT-10L manufactured by Toyo-Morton, Ltd. was used.

The laminated film is cut into two A5 size films (148 mm $\times$ 210 mm). The two films are sealed at three sides in a state where the films L4012 are overlapped, to form a bag. A seal width is 10 mm.

The bag is filled with 100 ml of a dilution obtained by diluting vinegar (manufactured by Mizkan, grain vinegar) to 50% with water, and sealed. The bag is placed in a room at 40°C and stored for 1 week.

After 1 week, the contents are taken out, washed with water, and dried, followed by measuring the oxygen transmission rate.

The acid resistance is evaluated by the oxygen transmission rate.

Example 1

First, aluminum was vapor-deposited on a substrate plastic film having a total light transmittance of 83% without oxygen being introduced with a target of a total light transmittance of 39%. The total light transmittance was stabilized, and the oxygen was then introduced to control the total light transmittance to 72%. The amount of oxygen introduced was 12278 sccm. A pressure in a vapor-deposition chamber after the introduction of oxygen was $1.5 \times 10^{-3}$ Pa. Table 1 shows the conditions of Example 1.

This transparent barrier film was rewound at a speed of 230 m/min using a slitter. From the diameter of the rewound rolled plastic film, the amount of air entrained was estimated to be contained at a thickness of about 0.4 $\mu$m between the plastic films.

The rewound transparent barrier film was stored in a room at 23°C for 3 weeks, and the total light transmittance was then measured with a turbidimeter to calculate an absorption coefficient. The results are shown in Table 2. The OTR and WVTR obtained by measuring the laminated film obtained by bonding the LLDEP to the transparent barrier film are shown in Table 2. Furthermore, the results of the acid resistance test are shown in Table 2.

[Table 1]

| | Total Light Transmittance % | | | Vapor-Deposition Conditions | | |
|---|---|---|---|---|---|---|
| | Substrate Plastic Film | Aluminum | Aluminum Oxide | Amount of Oxygen Introduced sccm | Pressure mPa | Film Traveling Speed m/min |
| Example 1 | 83 | 39 | 72 | 12278 | 1.5 | 600 |
| Example 2 | 85 | 28 | 69 | 12907 | 8.8 | 480 |
| Example 3 | 85 | 29 | 71 | 12797 | 9.2 | 480 |
| Example 4 | 85 | 26 | 72 | 13650 | 9.4 | 432 |
| Example 5 | 83 | 18 | 63 | 12517 | 1.4 | 333 |
| Example 6 | 83 | 18 | 69 | 13786 | 1.4 | 333 |
| Comparative Example 1 | 83 | 18 | 58 | 11447 | 1.4 | 333 |
| Comparative Example 2 | 83 | 8 | 44 | 10420 | 1.4 | 222 |
| Comparative Example 3 | 83 | 8 | 54 | 12231 | 1.4 | 222 |

Examples 2 to 6

In the same manner as in Example 1, vapor-deposition was performed under the conditions shown in Table 1. The results are shown in Table 2.

Comparative Examples 1 to 3

In the same manner as in Example 1, vapor-deposition was performed under the conditions shown in Table 1.
The results of evaluating the samples of Comparative Examples 1 to 3 are shown in Table 2.

[Table 2]

| | Film Thickness | Absorption Coefficient nm$^{-1}$ | | WVTR | OTR mL/m$^2$·d·Mpa | |
|---|---|---|---|---|---|---|
| | nm | Immediately After Vapor-Deposition | After 3 Weeks | g/m$^2$ day | Untreated | After Acid Resistance Test |
| Example 1 | 6 | 0.027 | 0.001 | 0.8 | 26 | 76 |
| Example 2 | 7 | 0.026 | 0.000 | 0.9 | 21 | 32 |

(continued)

|  | Film Thickness nm | Absorption Coefficient nm$^{-1}$ | | WVTR g/m$^2$ day | OTR mL/m$^2$·d·Mpa | |
|---|---|---|---|---|---|---|
|  |  | Immediately After Vapor-Deposition | After 3 Weeks |  | Untreated | After Acid Resistance Test |
| Example 3 | 7 | 0.024 | 0.000 | 1.0 | 18 | 21 |
| Example 4 | 7 | 0.020 | 0.000 | 1.0 | 24 | 28 |
| Example 5 | 10 | 0.029 | 0.000 | 0.6 | 15 | 40 |
| Example 6 | 10 | 0.022 | 0.000 | 0.9 | 31 | 43 |
| Comparati ve Example 1 | 11 | 0.034 | 0.004 | 0.6 | 9 | 824 |
| Comparati ve Example 2 | 19 | 0.036 | 0.015 | 2.3 | 10 | 871 |
| Comparati ve Example 3 | 15 | 0.030 | 0.007 | 5.0 | 12 | 399 |

In Comparative Examples with respect to Examples, the absorption coefficient immediately after vapor-deposition was higher than 0.03 nm$^{-1}$, whereby the value of the OTR after the acid resistance test was high, which caused impaired barrier properties.

INDUSTRIAL APPLICABILITY

The present invention makes it possible to provide a transparent barrier film that includes, as a barrier layer, an aluminum oxide layer that can be produced at a low cost to have excellent acid resistance and be capable of packaging a wide range of contents, and a method for producing the same.

DESCRIPTION OF REFERENCE SIGNS

1 Transmittance wavelength characteristics of substrate plastic film (12 $\mu$m-thick PET film)
2 Transmittance wavelength characteristics of transparent gas barrier film on which aluminum oxide layer is laminated
3 Spectral power wavelength characteristics of D65 light source
4 y color-matching function
5 Plastic film
6 Coating roll
7 Coating window
8 Oxygen inlet
9 Vapor-deposition source (resistance heating boat)
10 Unwinding roll
11 Plasma source
12 Optical film thickness meter
13 Winding roll

**Claims**

1. A transparent gas barrier film comprising a plastic film and an aluminum oxide layer provided on at least one surface of the plastic film, the aluminum oxide layer mainly composed of aluminum oxide, wherein:

    an absorption coefficient of the aluminum oxide layer immediately after vapor-deposition is less than 0.03 nm$^{-1}$; and

a film thickness of the aluminum oxide layer is 6 nm or more and 10 nm or less.

2. The transparent gas barrier film according to claim 1, wherein the absorption coefficient immediately after vapor-deposition is 0.02 $nm^{-1}$ or more.

3. The transparent gas barrier film according to claim 1 or 2, wherein the absorption coefficient is finally 0.002 $nm^{-1}$ or less.

4. A method for producing a transparent gas barrier film comprising a plastic film and an aluminum oxide layer provided on at least one surface of the plastic film, the aluminum oxide layer mainly composed of aluminum oxide,
the method comprising an aluminum oxide layer forming step of adjusting an absorption coefficient of the aluminum oxide layer immediately after vapor-deposition to less than 0.03 $nm^{-1}$ and adjusting a film thickness of the aluminum oxide layer to 6 nm or more and 10 nm or less.

5. The method according to claim 4, wherein in the aluminum oxide layer forming step, the absorption coefficient immediately after vapor-deposition is adjusted to 0.02 $nm^{-1}$ or more.

6. The method according to claim 4 or 5, wherein the aluminum oxide layer forming step is performed by using a reactive vapor-deposition method.

7. The method according to any one of claims 4 to 6, wherein the absorption coefficient is adjusted by controlling an amount of oxygen introduced into a vapor-deposition tank in the aluminum oxide layer forming step.

8. The method according to any one of claims 4 to 7, further comprising a step of finally adjusting the absorption coefficient to 0.002 $nm^{-1}$ or less after the aluminum oxide layer forming step.

9. The method according to claim 5, wherein the transparent gas barrier film is stored at normal temperature in an air atmosphere for 1 week or more in the step of adjusting the absorption coefficient to 0.002 $nm^{-1}$ or less.

Fig.1

Fig.2

Fig.3

Fig.4

Fig.5

**INTERNATIONAL SEARCH REPORT**

| | International application No. |
|---|---|
| | PCT/JP2020/020687 |

A. CLASSIFICATION OF SUBJECT MATTER
B32B 9/00(2006.01)i; C23C 14/08(2006.01)i; C23C 14/24(2006.01)i; C23C 14/58(2006.01)i
FI: C23C14/08 A; B32B9/00 A; C23C14/58 Z; C23C14/24 U
According to International Patent Classification (IPC) or to both national classification and IPC

B. FIELDS SEARCHED

Minimum documentation searched (classification system followed by classification symbols)
B32B9/00; C23C14/08; C23C14/24; C23C14/58

| Documentation searched other than minimum documentation to the extent that such documents are included in the fields searched | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2018/147137 A1 (TORAY ADVANCED FILM CO., LTD.) 16.08.2018 (2018-08-16) entire text | 1-9 |
| A | WO 2018/203526 A1 (TORAY ADVANCED FILM CO., LTD.) 08.11.2018 (2018-11-08) entire text | 1-9 |
| A | JP 2017-177343 A (TORAY ADVANCED FILM CO., LTD.) 05.10.2017 (2017-10-05) entire text | 1-9 |
| A | JP 2014-223788 A (TORAY ADVANCED FILM CO., LTD.) 04.12.2014 (2014-12-04) entire text | 1-9 |
| A | JP 2007-261134 A (TOPPAN PRINTING CO., LTD.) 11.10.2007 (2007-10-11) entire text | 1-9 |
| A | JP 6-87966 A (TONEN CORP.) 29.03.1994 (1994-03-29) entire text | 1-9 |

☒ Further documents are listed in the continuation of Box C.     ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 30 July 2020 (30.07.2020) | 11 August 2020 (11.08.2020) |

| Name and mailing address of the ISA/ | Authorized officer |
|---|---|
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**

| International application No. |
| --- |
| PCT/JP2020/020687 |

C (Continuation).    DOCUMENTS CONSIDERED TO BE RELEVANT

| Category* | Citation of document, with indication, where appropriate, of the relevant passages | Relevant to claim No. |
| --- | --- | --- |
| A | WO 2018/024313 A1 (APPLIED MATERIALS, INC.) 08.02.2018 (2018-02-08) entire text | 1-9 |
| P, A | JP 2019-181941 A (TORAY ADVANCED FILM CO., LTD.) 24.10.2019 (2019-10-24) entire text | 1-9 |

Form PCT/ISA/210 (continuation of second sheet) (January 2015)

**INTERNATIONAL SEARCH REPORT**

Information on patent family members

International application No.

PCT/JP2020/020687

| Patent Documents referred in the Report | Publication Date | Patent Family | Publication Date |
|---|---|---|---|
| WO 2018/147137 A1 | 16 Aug. 2018 | CN 110382233 A KR 10-2019-0116340 A | |
| WO 2018/203526 A1 | 08 Nov. 2018 | (Family: none) | |
| JP 2017-177343 A | 05 Oct. 2017 | (Family: none) | |
| JP 2014-223788 A | 04 Dec. 2014 | (Family: none) | |
| JP 2007-261134 A | 11 Oct. 2007 | (Family: none) | |
| JP 6-87966 A | 29 Mar. 1994 | (Family: none) | |
| WO 2018/024313 A1 | 08 Feb. 2018 | JP 2019-523349 A US 2019/0246504 A1 EP 3491161 A1 TW 201809331 A CN 109563607 A | |
| JP 2019-181941 A | 24 Oct. 2019 | (Family: none) | |

Form PCT/ISA/210 (patent family annex) (January 2015)

**EP 3 978 235 A1**

## REFERENCES CITED IN THE DESCRIPTION

**Patent documents cited in the description**

- JP 2638797 B
- JP 2007290292 A